# EUROPÄISCHE PATENTSCHRIFT

(11) **EP 1 444 740 B1**
(45) Veröffentlichungstag und Bekanntmachung des Hinweises auf die Patenterteilung: **29.11.2006**
(21) Anmeldenummer: 02783004.1
(22) Anmeldetag: 25.10.2002
(51) Int. Cl.: H01L 51/40

(54) **VERFAHREN ZUR TROCKNUNG VON SCHICHTEN ORGANISCHER HABLEITER, LEITER ODER FARBFILTER MITTELS IR UND/ODER NIR-STRAHLUNG**
METHOD FOR DRYING LAYERS OF ORGANIC SEMICONDUCTORS, CONDUCTORS OR COLOR FILTERS USING IR AND NIR RADIATION
PROCEDE POUR SECHER DES COUCHES DE SEMICONDUCTEURS, CONDUCTEURS OU FILTRES COLORES ORGANIQUES AU MOYEN D'UN RAYONNEMENT INFRAROUGE OU PROCHE INFRAROUGE

(30) Priorität: 30.10.2001 DE 10153445
(43) Veröffentlichungstag der Anmeldung: 11.08.2004
(73) Patentinhaber: Merck Patent GmbH, 64293 Darmstadt (DE)
(72) Erfinder: STEIGER, Jürgen, 60489 Frankfurt (DE); HEUN, Susanne, 65812 Bad Soden (DE); VESTWEBER, Horst, 34830 Gilserberg-Winterscheid (DE); WIENER, Manfred, 65719 Hofheim (DE); MATTHÄUS, Andreas, 65843 Sulzbach (DE)
(74) Vertreter: Benz, Jürgen
(86) Internationale Anmeldenummer: PCT/EP2002/011941
(87) Internationale Veröffentlichungsnummer: WO 2003/038923

(56) Entgegenhaltungen:
- EP-A- 0 132 248
- EP-A- 1 083 775
- WO-A-01/70506
- DE-U- 20 020 148
- DE-U- 20 020 604
- ANON: "Infrarot (IR) und ihre industrille Anwendung" KAUTSCHUK UND GUMMI - KUNSTSTOFFE, DR. ALFRED HUTHIG VERLAG GMBH. HEIDELBERG, DE, Bd. 36, Nr. 10, Oktober 1983 (1983-10), Seiten 899-901, XP002110442 ISSN: 0948-3276
- KUPFER K: "TROCKENSCHRANKVERFAHREN, INFRAROT- UND MIKROWELLENTROCKNUNG ALS REFERENZVERFAHREN ZUR BESTIMMUNG DER MATERIALFEUCHTE DRYING OVEN METHOD, INFRARED- AND MICROWAVE DRYING AS REFERENCE METHODS FOR DETERMINATION OF MATERIAL MOISTURE" TECHNISCHES MESSEN TM, R.OLDENBOURG VERLAG. MUNCHEN, DE, Bd. 66, Nr. 6, Juni 1999 (1999-06), Seiten 227-237, XP000919692 ISSN: 0171-8096
- PATENT ABSTRACTS OF JAPAN vol. 018, no. 277 (E-1554), 26. Mai 1994 (1994-05-26) & JP 06 053132 A (NIPPON TELEGR & TELEPH CORP), 25. Februar 1994 (1994-02-25)
- PATENT ABSTRACTS OF JAPAN vol. 011, no. 137 (P-572), 2. Mai 1987 (1987-05-02) & JP 61 277958 A (MITA IND CO LTD), 8. Dezember 1986 (1986-12-08)
- PATENT ABSTRACTS OF JAPAN vol. 2000, no. 11, 3. Januar 2001 (2001-01-03) & JP 2000 231737 A (SONY CORP), 22. August 2000 (2000-08-22)

## Beschreibung

Die vorliegende Erfindung betrifft ein Verfahren zur Trocknung von Schichten organischer Halbleiter, organischer Farbfilter oder organischer Leiter und die dadurch erzeugten Schichten dieser organischen Halbleiter, organischen Farbfilter oder organischen Leiter.

In einer Reihe von verschiedenartigen Anwendungen, die im weitesten Sinne der Elektronikindustrie zugerechnet werden können, ist der Einsatz organischer Halbleiter, organischer Farbfilter oder organischer Leiter als Wirkkomponenten (= Funktionsmaterialien) seit geraumer Zeit Realität bzw. wird in naher Zukunft erwartet.

Schon seit etlichen Jahren finden Ladungstransportmaterialien auf organischer Basis (i. d. R. Lochtransporter auf Triarylaminbasis) Verwendung in Kopiergeräten. Die Verwendung spezieller halbleitender organischer Verbindungen, die zum Teil auch zur Emission von Licht im sichtbaren Spektralbereich befähigt sind, steht gerade am Anfang der Markteinführung, zum Beispiel in organischen bzw. polymeren Elektrolumineszenz-Vorrichtungen.
Die Verwendung organischer Ladungstransportschichten in Anwendungen wie organischen integrierten Schaltungen (organischen ICs) und organischen Solarzellen ist zumindest im Forschungsstadium schon sehr weit gediehen, so daß eine Markteinführung innerhalb der nächsten Jahre erwartet werden kann.
Die Anzahl weiterer Möglichkeiten ist sehr groß, häufig jedoch nur als Abwandlung der oben aufgeführten Prozesse zu sehen, wie die Beispiele organische Feststofflaserdioden und organische Photodetektoren belegen.
Bei einigen dieser modernen Anwendungen ist die Entwicklung teilweise bereits sehr weit fortgeschritten, dennoch besteht - je nach Applikation - immer noch ein immenser Bedarf an technischen Verbesserungen.
In all diesen Vorrichtungen kommen i. d. R. dünne Schichten der organischen Halbleiter oder organischen Leiter zum Einsatz.

Dünne Schicht bedeutet hier, daß die Schichtdicken im Bereich von 10 nm bis 10 µm liegen, meist jedoch kleiner als 1 µm sind.

Ein weitverbreiteter Prozeß zum Erzeugen dieser dünnen Schichten ist das Aufbringen von Lösungen oder Dispersionen der entsprechenden organischen Halbleiter oder organischen Leiter.
Dieses Aufbringen kann auf mannigfaltige Arten erfolgen:
- Es eignen sich typische einfache Beschichtungsverfahren, wie z. B. Rakeln, Spin-Coaten, Meniskus-Coating, Tauchbeschichtung, AirBrush-Beschichtung (Sprühcoating) und weitere davon abgewandelte Verfahren.
- Als höheraufgelöste Aufbringungsmethoden eignen sich prinzipiell verschiedene Druckverfahren, wie z. B. Offset-Druck, Tintenstrahldrucken (IJP = Ink Jet Printing), Transferdruck, Siebdruck und weitere hier nicht explizit aufgeführte Druckverfahren.
All diesen Verfahren ist folgendes gemeinsam: Es werden Lösungen oder Dispersionen der entsprechenden organischen Halbleiter- oder organischen Leiter-Verbindungen eingesetzt. Dabei ist in aller Regel die Konzentration der Wirkkomponente relativ gering und beträgt üblicherweise zwischen 0.01 und 20 Gew%.
Dies bedeutet nun, daß nach dem Aufbringen die Naßfilmdicke um ein Vielfaches (häufig mehr als 100 mal) größer ist als die Festfilmdicke des getrockneten Naßfilms. Von hoher Bedeutung ist daher, einen effizienten, reproduzierbaren Prozeß beim Trocknen zu verwenden, der auch dazu führt, daß alles Lösemittel entfernt wird.
Dieser extrem wichtige Prozeß wurde bis dato in aller Regel überhaupt nicht beachtet. Die Lösungen bzw. Dispersionen wurden aufgebracht, danach wurde eine Weile abgewartet, woraufhin dann weitere Prozeßschritten folgten. Wenn hochsiedende Lösemittel (z. B. Tetralin, Sdp. 206°C; Dodecylbenzol, Sdp. >300°C) oder auch schwerflüchtige (wie z. B. Wasser) eingesetzt wurden, wurde häufig ein Temperprozeß, teilweise im Vakuum vorgeschlagen bzw. durchgeführt.
So wird beispielsweise in EP-A-1083775 für die o. g. hochsiedenden Lösemittel berichtet, daß die Trocknung im Bereich von 100 bis 200°C, teilweise unter Unterdruck (2 mbar) bzw. in einer Stickstoffatmosphäre für 1 bis 10 Minuten durchgeführt wird. In der hier zitierten Patentanmeldung werden Schichten organischer Halbleiter für die Verwendung in PLEDs (Polymer LEDs) beschrieben, welche durch IJP erzeugt wurden.

In EP-A-991303 wird beispielsweise berichtet, daß Filme organischer Leiter (hier: PEDOT, ein Poly-thiophenderivat, welches in wässriger Dispersion von der Bayer AG, Leverkusen, unter dem Namen BAYTRON-P^{™} kommerziell erhältlich ist) dadurch getrocknet werden, daß diese für 5 Minuten bei 110°C getempert werden.

Diese Beispiele belegen, daß die Trocknung entsprechender dünner Filme relativ aufwendig und langwierig ist. Wichtig ist, hier zu vermerken, daß häufig für die entsprechende Anwendung ein vollständiges Entfernen des entsprechenden Lösemittels von entscheidender Bedeutung ist (vgl. auch Beispiel 1).

Nachteilig an den oben zitierten und heute allgemein angewandten Verfahren, dünne Schichten organischer Halbleiter, organischer Farbfilter bzw. organischer Leiter zu trocknen, ist folgendes:
- Wärmezufuhr durch eine Heizplatte ist zwar im Laborbetrieb einfach durchzuführen, in einem technischen Prozeß bereitet dies erhebliche Probleme.
- Vakuumprozesse sind immer zeitintensiv und teuer. Für technische Verfahren versucht man ihre Anwendung daher soweit möglich zu beschränken.
- Ein extrem wichtiger Punkt ist der Zeitbedarf. Die meisten Prozesse für die Massenfertigung entsprechender Vorrichtungen können nur dann wirtschaftlich betrieben werden, wenn die Gesamtprozeßzeit im Bereich weniger Minuten liegt. Werden hier allein bei einem Schritt (von i. d. R. sehr vielen) mehrere Minuten ausschließlich für die Trocknung benötigt, kann dies zu einer Nichtverwendbarkeit der gesamten Technologie führen.

Es besteht daher ein deutlicher Bedarf, verbesserte Verfahren zur Trocknung entsprechender Schichten zu entwickeln.
In der deutschen Gebrauchsmusterschrift DE 20020604 U1 wird nun eine Vorrichtung zur Trocknung von derartigen bzw. ähnlichen Schichten vorgeschlagen, die im wesentlichen auf der Anwendung von IR bzw. NIR (IR = InfraRot, d. h. Licht mit einer Wellenlänge von mehr als 700 nm; NIR = Nahes IR, d. h. Licht mit einer Wellenlänge im Bereich von ca. 700 bis 2000 nm bzw. einer Energie im Bereich von ca. 0.6 bis 1.75 eV) besteht. Es wird beschrieben, daß eine entsprechende IR- bzw. NIR-Quelle möglichst direkt in die Beschichtungsapparatur integriert wird. Des weiteren wird noch die Möglichkeit eines additiven Gasstroms erörtert.
In dieser Gebrauchsmusterschrift werden aber keine praktischen Hinweise auf die tatsächliche Verwendung gemacht. So werden keinerlei Angaben über den Zeitbedarf gegeben. Auch sind leider keine weiteren Details zu entnehmen. Die in dieser Schrift gemachte Angabe, daß eine Quarzlampe bei erhöhter Temperatur verwendet wird, kann in der Anwendung sogar zu massiven Problemen führen. Strahlt die Lampe dann neben dem IR bzw. NIR-Anteil noch große Mengen sichtbaren Lichts bzw. UV-Lichts ab, kann dies die entsprechenden Schichten stark schädigen, v. a. wenn die Einwirkung unter normaler Atmosphäre bzw. über einen längeren Zeitraum stattfindet (vgl. beispielsweise Synth. Met. **2000**, 111-112, 553-557). Die hier beschriebene Vorrichtung ist daher nur begrenzt geeignet, eine entsprechende Verbesserung zu erwirken.

Es wurde nun aber überraschend gefunden, daß sich sehr gutes Trocknungsverhalten erzielen läßt, wenn der Naßfilm eines organischen Halbleiters bzw. organischen Leiters nach der Beschichtung bzw. Aufbringung auf ein Substrat mit entsprechender IR- bzw. NIR-Strahlung behandel wird. Auf diese Weise kann eine vollständige Trocknung des Naßfilms bereits in weniger als 60 Sekunden, meist auch weniger als 30 Sekunden, häufig sogar weniger als 10 Sekunden, in manchen Fällen weniger als 1 Sekunde, in einigen Fällen weniger als 0,1 Sekunden bewerkstelligt werden.

Vollständige Trocknung bedeutet hier, daß in der fertigen Festfilmschicht weniger als 1 % (bezogen auf die Masse), bevorzugt weniger als 0.1%, besonders bevorzugt weniger als 10 ppm, ganz besonders bevorzugt weniger als 1 ppm Lösemittel enthalten sind.
Wichtig für gute Filmbildung und Vermeidung von negativen Effekten bei der Trocknung ist folgendes:
- Die abgegebene Strahlungsleistung pro Fläche muß hoch genug sein, um tatsächlich vollständige Trocknung in der angegebenen kurzen Zeit zu erreichen, bevorzugt größer 75 kW/m². Geringere Strahlungsintensitäten bewirken eine längere Trocknungsdauer.
- Es sollte möglichst wenig sichtbares Licht (d. h. Licht mit Wellenlängen im Bereich von 400 bis 700 nm) bzw. UV-Licht (d. h. Licht mit Wellenlängen kleiner 400 nm) abgegeben werden. Erfindungsgemäß wird eine Strahlung verwendet wobei mindestens 80% der Strahlungsenergie im Bereich von 700 bis 2000 nm abgegeben wird, besonders bevorzugt wenn dies mehr als 95%, ganz besonders bevorzugt, wenn dies mehr als 99% ist. Sollten entsprechende Lampen bzw. IR-Abgabevorrichtungen dies nicht ermöglichen, ist es natürlich auch eine Möglichkeit, durch einen entsprechenden Filter die kürzeren Wellenlängen zu entfernen.

Gegenstand der Erfindung ist daher ein Verfahren zur Erzeugung dünner Schichten von organischen Halbleitern, organischen Leitern oder organischen Farbfiltern umfassend die Schritte:
(a) Aufbringen von Lösungen oder Dispersionen enthaltend mindestens einen organischen Halbleiter oder organischen Leiter oder organischen Farbfilter auf ein Substrat,
(b) Trocknung des gemäß Schritt (a) erzeugten Naßfilms mittels IR- und/oder NIR-Strahlung,
dadurch gekennzeichnet, daß in Schritt (b) eine Strahlung eingesetzt wird bei der mindestens 80% der Strahlungsenergie im Bereich von 700 bis 2000 nm liegt.

Das Aufbringen der Lösung bzw. Dispersion in Schritt (a) kann mit jedem beliebigen Verfahren erfolgen. Beispiele hierfür sind Spin-Coating, Rakeln, Meniskus-Coating, Tauchbeschichten, AirBrush-Beschichten, aber auch Offset-Drucken, Tintenstrahldrucken, Transferdrucken oder Siebdrucken und auch weitere hier nicht explizit genannte Verfahren.

Bevorzugt ist dabei, wenn die entsprechende Strahlungseinwirkung weniger als 60 Sekunden, bevorzugt weniger als 30 Sekunden, besonders bevorzugt weniger als 10 Sekunden, ganz besonders bevorzugt weniger als 1 Sekunde, insbesondere ganz besonders bevorzugt weniger als 0.1 Sekunden stattfindet, dabei aber trotzdem eine vollständige Trocknung erreicht wird.
Deshalb ist es weiterhin bevorzugt, daß die entsprechende Bestrahlung mit einer Intensität von mehr als 75 kW/m², bevorzugt von mehr als 150 kW/m² besonders bevorzugt von mehr als 300 kW/m² angewandt wird.

Wie oben erläutert ist es weiterhin bevorzugt, daß mindestens 95%, besonders bevorzugt mindestens 99% der Strahlungsenergie durch Licht mit einer Wellenlänge im Bereich von 700 bis 2000 nm in die Naßfilmschicht eingetragen wird.

In einer weiteren bevorzugten Ausführungsform wird eine IR-/NIR-Strahlung verwendet deren Wellenlänge im Bereich mehr als von 700 nm bis 2000 nm, insbesondere bevorzugt im Bereich von 800 nm bis 1500nm liegt.

Bevorzugt ist dabei weiterhin, daß diese Trocknung unmittelbar nach der Beschichtung erfolgt, am besten die Trockungsvorrichtung in die Beschichtungsvorrichtung integriert ist.

In einer besonderen Ausführung des Trocknungsverfahrens kann es weiter bevorzugt sein, wenn die Trocknung schon während des Beschichtens stattfindet, bzw. begonnen wird.

Darüber hinaus kann es weiterhin vorteilhaft sein, wenn neben der Strahlungseinwirkung noch weitere die Trocknung beschleunigende Prozesse eingesetzt werden. Dies kann dazu führen, daß die Gesamttrocknungszeit noch weiter verkürzt wird und auch die Filmmorphologie noch weiter verbessert wird, ohne bei diesem Phänomen an eine besondere Theorie gebunden zu sein. Mögliche weitere Prozesse sind hier die kurzfristige Erhöhung der Temperatur, der schnelle Austausch des Gasraumes (z. B. mit einem inerten Gas wie Stickstoff oder Argon), oder auch das Absenken des Umgebungsdrucks.

Das erfindungsgemäße Verfahren weist nun folgende Vorteile gegenüber dem o. g. Stand der Technik auf:
- Es bietet eine effiziente und schnelle Möglichkeit, die genannten Schichten vollständig zu trocknen.
- Das Verfahren verläuft schonend und liefert sehr gute Resultate für die entsprechenden Anwendungen (vgl. auch Beispiele 3-8).
- Das Verfahren führt zu keiner Schädigung der entsprechenden Filme, da potentiell schädliche Lichtwellenlängen weitestgehend ausgeschlossen werden.

Darüber hinaus wurde überraschenderweise gefunden, daß durch eine Nachbehandlung bereits herkömmlich getrockneter Schichten organischer Halbleitern, organischer Leitern oder organischer Farbfilter mit einer IR/NIR-Strahlung, bei der mindestens 80% der Strahlungsenergie im Bereich von 700 bis 2000 nm liegt, weitere Vorteile bezüglich deren Anwendungseigenschaften auftreten. Diese sind u. a. in Beispiel 8 der vorliegenden Anmeldung beschrieben. Auch diese Verfahren ist Gegenstand der vorliegenden Erfindung.

Deshalb ist ein weiterer Erfindungsgegenstand die Nachbehandlung bereits herkömmlich getrockneter Schichten organischer Halbleiter, organischer Leiter oder organischer Farbfilter mit einer IR/NIR-Strahlung bei der mindestens 80% der Strahlungsenergie im Bereich von 700 bis 2000 nm liegt.

Die hier verwendeten Begriffe sind analog dem oben Beschriebenen definiert. Die bevorzugten Bereiche sind auch für das Nachbehandlungsverfahren gültig.

Die erzielten Schichten sowohl durch das Trocknungs- (vgl. auch Beispiele 3-7) als auch das Nachbehandlungsverfahren (vgl. Beispiel 8) weisen deutliche Vorteile bezüglich ihrer Morphologie gegenüber herkömmlich getrockneten Schichten auf, ohne bei diesem Phänomen an eine besondere Theorie gebunden zu sein. Deshalb sind diese Schichten neu und damit ebenfalls Gegenstand der vorliegenden Erfindung.

Gegenstand der Erfindung sind auch Schichten organischer Halbleiter, organischer Farbfilter bzw. organischer Leiter dadurch gekennzeichnet, daß diese durch eines der beiden erfindungsgemäßen Verfahren getrocknet bzw. nachbehandelt wurden.

Die o. g. erfindungsgemäßen Schichten finden Verwendung in entsprechenden Vorrichtungen, wie z. B. polymeren organischen Leuchtdioden (PLEDs), organischen integrierten Schaltungen (O-ICs), organischen Feld-Effekt-Transistoren (OFETs), organischen Dünnfilmtransistoren (OTFTs), organischen Solarzellen (O-SCs), organischen Laserdioden (O-Laser), organischen Farbfilter für Liquid-Crystal-Displays oder organischen Photorezeptoren. Da die Morphologie - wie oben beschrieben - deutliche Vorteile gegenüber herkömmlich getrockneten Schichten aufweist, sind auch entsprechende Vorrichtungen, enthaltend erfindungsgemäße Schichten, ein weiterer Gegenstand der vorliegenden Erfindung.

Gegenstand der vorliegenden Erfindung sind also polymere organische Leuchtdioden (PLEDs), organische integrierte Schaltungen (O-ICs), organische Feld-Effekt-Transistoren (OFETs), organische Dünnfilmtransistoren (OTFTs), organische Solarzellen (O-SCs), organische Laserdioden (O-Laser) oder organischer Photorezeptoren dadurch gekennzeichnet, daß diese erfindungsgemäße Schichten enthalten.

Die erfindungsgemäßen Verfahren können nun für die Herstellung einer großen Vielzahl von Schichten organischer Halbleiter, organischer Farbfilter bzw. organischer Leiter Verwendung finden.

Organische Halbleiter sind beispielsweise die im folgenden beschriebenen:
Allgemein sind organische Halbleiter im Sinne dieser Erfindung organische oder auch metallorganische Verbindungen, die - als Feststoff bzw. als konkrete Schicht - halbleitende Eigenschaften aufweisen, d. h. bei denen die Energielücke zwischen Leitungs- und Valenzband zwischen 0.1 und 4 eV liegt.

Organische Halbleiter sind zum einen niedermolekulare organische Halbleiter auf Basis von Triarylaminen (Proc. SPIE-Int. Soc. Opt. Eng. **1997**, 3148, 306-312), Aluminium-tris-(8-hydroxy-chinolin) (Appl. Phys. Lett. **2000**, 76(1), 115-117), Pentacene (Science **2000**, 287(5455), 1022-1023), Oligomere (Opt. Mater. **1999**, 12(2/3), 301-305), weitere kondensierte aromatische Systeme (Mater. Res. Soc. Symp. Proc. **2000**, 598, BB9.5/1-BB9.5/6) und weitere Verbindungen, wie sie beispielsweise in *J. Mater. Chem.* **2000**, 10(7), 1471-1507 und Handb. Adv. Electron. Photonic Mater. Devices **2001**, 10, 1-51 beschrieben sind. Diese können alleine oder auch in geeigneten Matrixmaterialien, wie z.B. Polystyrol (PS) oder Polycarbonat (PC), eingesetzt werden. Die in den vorstehend genannten Stellen offenbarten niedermolekularen Halbleiter sind durch Zitat Bestandteil der vorliegenden Beschreibung.

Des weiteren und auch bevorzugt werden jedoch polymere organische oder metallorganische Halbleiter verwendet.
Als polymere organische Halbleiter im Sinne der vorliegenden Beschreibung werden insbesondere
(i) die in EP-A-0443861, WO 94/20589, WO 98/27136, EP-A-1025183, WO 99/24526, DE-A-19953806 und EP-A-0964045 offenbarten, in organischen Lösemitteln löslichen, substituierten Poly-p-Arylen-Vinylene (PAVs),
(ii) die in EP-A-0842208, WO 00/22027, WO 00/22026, DE-A-19981010, WO 00/46321, WO 99/54385, WO 00/55927 offenbarten, in organischen Lösemitteln löslichen, substituierten Poly-Fluorene (PFs),
(iii) die in EP-A-0707020, WO 96/17036, WO 97/20877, WO 97/31048, WO 97/39045 offenbarten, in organischen Lösemitteln löslichen, substituierten Poly-Spirobifluorene (PSFs),
(iv) die in WO 92/18552, WO 95/07955, EP-A-0690086, EP-A-0699699 offenbarten, in organischen Lösemitteln löslichen, substituierten Poly-Paraphenylene (PPPs),
(v) die in EP-A-1028136, WO 95/05937 offenbarten, in organischen Lösemitteln löslichen, substituierten Polythiophene (PTs),
(vi) die in T. Yamamoto et al., *J. Am. Chem. Soc.* **1994**, *116*, 4832 offenbarten, in organischen Lösemitteln löslichen Polypyridine (PPys),
(vii) die in V. Gelling et al., *Polym. Prepr.* **2000**, *41*, 1770 offenbarten in organischen Lösemitteln löslichen Polypyrrole,
(viii) substituierte, lösliche Copolymere, die Struktureinheiten von zwei oder mehr der Klassen (i) bis (vii) aufweisen,
(ix) die in *Proc. of ICSM '98,* **Part I & II** (in: *Synth. Met.* **1999,** *101* + *102*) offenbarten, in organischen Lösemitteln löslichen konjugierten Polymere,
(x) substituierte und unsubstituierte Poly-vinyl-carbazole (PVKs), wie beispielsweise in R. C. Penwell et al., *J. Polym. Sci., Macromol. Rev.* **1978**, *13, 63-160* offenbart und
(xi) substituierte und unsubstituierte Triarylaminpolymere, wie vorzugsweise die in JP 2000-072722 offenbarten,
(xii) die von Suzuki et al. in Polym. Adv. Technol. 2000, 11(8-12), 460-467 und von Hoshino et al. in J. Appl. Phys. 2000, 87(4), 1968-1973 beschriebenen Polysilane, verstanden.
Diese polymeren organischen Halbleiter sind durch Zitat Bestandteil der vorliegenden Erfindung.

Polymere metallorganische Halbleiter sind beispielsweise in der nicht-offengelegten Anmeldeschrift DE 10114477.6 beschrieben, z. B. metallorganische Komplexe, die in Polymere einpolymerisiert sind.

Die erfindungsgemäß eingesetzten polymeren organischen Halbleiter können auch - wie oben beschrieben - dotiert und/oder als Blend untereinander eingesetzt werden.
Dotiert soll hier bedeuten, daß ein oder mehrere niedermolekulare Substanzen in das Polymer eingemischt werden; Blends sind Mischungen von mehr als einem Polymer, welche nicht zwangsweise alle halbleitende Eigenschaft zeigen müssen.

Organische Leiter können dadurch beschrieben werden, daß die elektronischen Zustände im Leitungsband nur teilweise mit Elektronen besetzt sind. Im folgenden wird von organischen Leitern gesprochen, wenn die spezifische Leitfähigkeit σ mindestens 10⁻⁸ Scm⁻¹ beträgt.

Für das erfindungsgemäße Verfahren müssen nun die oben beschriebenen organischen Halbleiter bzw. organischen Leiter aus Lösung bzw. Dispersion zunächst auf ein Substrat aufgebracht werden.

Diese Lösung bzw. Dispersion besteht nun beispielsweise aus den oben beschriebenen organischen Halbleitern bzw. organischen Leitern und einem oder mehreren Lösemitteln und eventuell noch weiteren Zusatzstoffen.
Beispiele für verwendbare Lösemittel sind mannigfaltig:
Häufig finden für organische Leiter bzw. organische Halbleiter aromatische Lösemittel, wie substitierte Benzole (z. B. Toluol, Anisol, Xylole), Heteroaromaten (wie z. B. Pyridin und einfache Derivate), Ether (wie z. B. Dioxan) und weitere organische Lösemittel Verwendung.

Es sind auch schon in verschiedenen Patent-Anmeldungen Lösemittel speziell für Lösungen polymerer Halbleiter beschrieben.
- So werden in EP-A-1083775 vor allem hochsiedende aromatische Lösemittel mit einem bevorzugten Siedepunkt über 200°C vorgeschlagen, die folgendes Kennzeichen aufweisen: es handelt sich um Benzolderivate, die mindestens drei C-Atome in der oder den Seitenketten besitzen. Bevorzugt werden in der genannten Anmeldung Lösemittel wie Tetralin, Cyclohexyl-benzol, Dodecylbenzol und ähnliche genannt.
- EP-A-1103590 berichtet in Analogie dazu allgemein von Lösemitteln mit einem Dampfdruck (bei der Temperatur des Beschichtungsprozesses) von weniger als 500 Pa (5 mbar), bevorzugt von weniger als 250 Pa (2.5 mbar) und beschreibt hierzu erneut Lösemittel oder Lösemittelgemische von hauptsächlich (hoch)substituierten Aromaten.
- In der nicht offengelegten Anmeldeschrift DE 10111633.0 werden hingegen Lösemittelgemische, bestehend aus mindestens zwei verschiedenen Lösemitteln, von denen eines im Bereich von 140 bis 200°C siedet, genannt. Im allgemeinen werden hier ebenfalls Lösemittelgemische, die hauptsächlich organische Lösemittel, wie Xylole, substituierte Xylole, Anisol, substituierte Anisole, Benzonitril, substituierte Benzonitrile, oder auch Heterocyclen, wie Lutidin oder Morpholin, enthalten, beschrieben.
   Dies können nun beispielsweise Mischungen aus Lösemitteln der unten aufgeführten Gruppe A mit solchen der Gruppe B sein.
   **Gruppe A:**
      o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, 4-Fluoranisol, 3-Fluoranisol, 3-Trifluormethylanisol, 2-Methylanisol, Phenetol, 4-Methylanisol, 3-Methylanisol, 4-Fluor-3-methyl-anisol, 2-Fluorbenzonitril, 4-Fluor-veratrol, 2,6-Dimethylanisol, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol oder N-Methylpyrrolidinon.
   **Gruppe B:**
      3-Fluor-benzotrifluorid, Benzotrifluorid, Dioxan, Trifluormethoxybenzol, 4-Fluor-benzotrifluorid, 3-Fluor-pyridin, Toluol, 2-Fluor-toluol, 2-Fluor-benzotrifluorid, 3-Fluor-toluol, Pyridin, 4-Fluor-toluol, 2,5-Difluor-toluol, 1-Chlor-2,4-difluorbenzol, 2-Fluor-pyridin, 3-Chlorfluorbenzol, 1-Chlor-2,5-difluorbenzol, 4-Chlorfluorbenzol, Chlorbenzol, 2-Chlorfluorbenzol, p-Xylol oder m-Xylol.
- In der ebenfalls noch nicht offengelegten Anmeldeschrift DE 10135640.4 werden analoge Lösemittel wie die o. g. benutzt, neben den polymeren Halbleitern und den Lösemitteln jedoch noch weitere Additive, bevorzugt Siloxan-haltige Additive verwendet.

Des weiteren kommt gerade für organische Leiter auch Wasser als Lösemittel oder als Dispersionsmittel in Betracht. Darüber hinaus können gerade für organische Leiter noch weitere i. d. R. stark polare organische Lösemittel, wie z. B. DMF, NMP, Glykol und seine Ether/Ester-Derivate, DMSO, DMAc, Alkohole, Carbonsäuren, Kresole und ähnliche, sowie Gemische aus diesen, Verwendung finden.

Die erfindungsgemäßen Schichten können nun durch die Verwendung von Lösungen bzw. Dispersionen, beispielsweise enthaltend die o. g. Lösemittel oder auch Gemische daraus und beispielsweise enthaltend die o. g. organischen Halbleiter bzw. organischen Leiter, hergestellt werden.

Die Herstellung kann - wie oben bereits erwähnt - beispielsweise durch folgende Methoden erfolgen:
- Spin-Coaten: Dieser Prozeß ist beispielsweise für die Herstellung organischer Halbleiter- und/oder organischer Leiterschichten für die Verwendung in PLEDs in EP 423283, für die Verwendung in Organischen Solarzellen in Sol. Energy Mater. Sol. Cells **2000**, 61(1), 63-72, für die Verwendung in OFETs in Synth. Met. **1997**, 89(3), 193-197, und für weitere Verwendungen in Solid State Technol. **1987**, 30(6), 67-71 beschrieben.
- Ink Jet Printing: Dieser Prozeß ist beispielsweise für die Herstellung organischer Halbleiter- und/oder organischer Leiterschichten für die Verwendung in PLEDs in EP-A-880303 und Appl. Phys. Lett. **1998**, 73(18), 2561-2563 und für die Verwendung in organischen Transistoren in Science **2000**, 5499, 2123-2125 beschrieben. Dieser Prozeß ist für die Herstellung von Farbfiltern in JP 11072614, JP 2000187111 und JP 2001108819 beschrieben.
- Screen-Printing: Dieser Prozeß ist beispielsweise für die Herstellung organischer Halbleiter- und/oder organischer Leiterschichten für die Verwendung in PLEDs in Appl. Phys. Lett. **2001**, 78(24), 3905-3907 beschrieben.
- Micro-contact printing: Diese Prozeß ist beispielsweise für die Herstellung organischer Halbleiter- und/oder organischer Leiterschichten für die Verwendung in PLEDs in Polym. Prepr. **1999**, 40(2), 1248-1249 beschrieben.

Das erfindungsgemäße Verfahren (Trocknung) besteht nun darin, daß nachdem die entsprechende Schicht (Naßfilm) aufgebracht wurde, die Einwirkung der Strahlung beginnt. Bevorzugt geschieht dies möglichst direkt nach dem Aufbringen des Naßfilms innerhalb von 60 Sekunden, bevorzugt innerhalb von 30 Sekunden, besonders bevorzugt innerhalb von 10 Sekunden, ganz besonders bevorzugt innerhalb von 1 Sekunde, insbesondere ganz besonders bevorzugt innerhalb von 0.1 Sekunden. In einer weiteren Ausführungsform des Trocknungsverfahrens beginnt die Trocknung des Naßfilmes bereits während des Beschichtens.

Die erfindungsgemäße Trocknung kann nun wie folgt durchgeführt werden:
Nach dem Aufbringen der Schicht wird das beschichtete Substrat unter einen Strahler gelegt. In einer besonderen Ausführung der Trocknung wird der Strahler in das Beschichtungsgerät integriert, so daß bereits während der Beschichtung mit der Trocknung begonnen werden kann. Dieser Strahler zeichnet sich dadurch aus, daß Strahlung mit Wellenlängen im Bereich von 700nm bis 1500nm abgegeben wird.

Als Strahlungsquelle können inkohärente Strahlungsquellen oder kohärente Strahlungsquellen verwendet werden. Als inkohärente Strahlungsquellen können z.B. Quecksilberlampen, Halogenlampen, Gasentladungslampen oder Xe-Lampen Verwendung finden. Solche Strahlungsquellen sind z.B. im Lehrbuch der Experimentalphysik, Band III: Optik, Hrsg. H. Gobrecht, 1987, 8. Auflage (Walter de Gruyter) beschrieben. Als kohärente Strahlungsquellen können Gaslaser, Halbleiterlaser oder Festkörperlaser verwendet werden. Solche Strahlungsquellen sind z.B. in Laser, J. Eichler und H. J. Eichler, 1991 (Springer Verlag), beschrieben. Die Strahlungsquellen besitzen bevorzugt ein Gehäuse, welches im nahen Infrarot und im Infrarot transparent ist, jedoch die Strahlung im sichtbaren und UV Bereich blockiert. Die hierbei im Lampengehäuse absorbierte Leistung kann durch geeignete Kühlung abgeführt werden. Die Strahlungsquellen zeichnen sich weiter dadurch aus, daß die oben beschriebenen Leistungsdichten bei ausreichender Lebensdauer der Strahlungsquelle erreicht werden können.

Bevorzugt ist die Verwendung von Halogenlampen mit Leistungsdichten von über 75kW/m², besonders bevorzugt von 150kW/m², insbesondere bevorzugt mit über 300kW/m². Bevorzugt ist weiter die Verwendung von geeigneten Reflektoren, die eine möglichst großflächige und homogene Bestrahlung des gesamten beschichteten Bereiches des Substrates erlauben. Solche Strahlungsquellen und Reflektoren werden z.B. in den deutschen Gebrauchsmusterschriften DE 20020148 und DE 20020319 beschrieben. In einer speziellen Ausführung des Trocknungsverfahrens können auch Reflektoren bevorzugt sein, welche die Strahlung fokusieren.

Da Strahlung im sichtbaren Bereich und UV Bereich die organischen Materialien schädigt (vergleiche Beispiel 2), ist weiter der Einsatz einer Einrichtung zur Filterung des sichtbaren und/oder des ultravioletten Wellenlängenbereiches der Strahlungsquelle bevorzugt. Diese Filterung kann durch ein absorbierendes oder Interferenz aufweisendes Medium geschehen.

Als Strahlungsquellen eignen sich weiter IR bzw. NIR Laser, die fokusiert oder nicht fokusiert zur Trocknung der dünnen Schichten Strahlung im Wellenlängenbereich von 700nm bis 1500nm abgeben. Die Laser können entweder gepulst oder im Dauerbetrieb betrieben werden. Weiter können die Laser fokusiert oder nicht fokussiert betrieben werden. Mittels Diffusoren können flächige Anordnungen von Lasern auch zum flächigen Trocknen verwendet werden. Ein Vorteil bei der Verwendung von Lasern liegt darin, daß keine weiteren Filter zur Filterung des UV-und sichtbaren Wellenlängenbereichs verwendet werden müssen. Des weiteren können durch die Fokussierung des Laserstrahls sehr hohe Leistungsdichten erreicht werden. Die Verwendung eines fokussierten Strahles ist insbesondere bei Drucktechniken wie z.B. Inkjet vorteilhaft, da mit dem fokusierten IR-Laser jeweils die frisch aufgebrachten Tropfen direkt nach dem Drucken getrocknet werden können, während die übrige Beschichtung des Substrates noch in Gange ist.

In einer weiteren Ausführungsform kann ein einzelner bedruckter Bereich, z.B. ein einzelner Pixel, Transistor, ein Bildelement oder Bauelement durch einen oder mehrere Laser-Strahlen geeigneter Wellenlänge getrocknet werden. Dabei kann der Fokus des Laserstrahles sowohl etwas größer, etwas kleiner oder etwa gleich groß wie der bedruckte Bereich sein.

Als Laser auf Basis von Halbleiterelementen kommen z.B. die Modelle SLD301, SLD302, SLD304, SLD322, SLD323, SLD324, SLD326, SLD327, SLD402 des Herstellers Sony, die Modelle ASM808-20CS, ASM808-20W2, ASM808-40CS, ASM808-40W2, ASM980-20W2, ASM980-20W2, ASM980-40CS, ASM980-40W2, die über ThorLabs (Newton, New Jersey, USA) bezogen werden können, und die mittels Laserdioden gepumpten Festkörperlaser 581FS302, 581FS303, 581FS301, die über Melles Griot (Ottawa, Ontario, Kanada) bezogen werden können, in Frage. Diese Laserdioden zeichnen sich dadurch aus, daß die emittierten Wellenlängen im Dauerbetrieb im Bereich zwischen 770nm und 1100nm bei Leistungen von 0.090W bis 40W erzeugt werden. Weiter kommen als gepulste Laser z.B. die Laser der Modellreihe NanoLaser in Frage, welche über Newport (Irvine, Kalifornien, USA) bezogen werden können. Diese Laser zeichnen sich durch Wellenlängen bis zu 1100nm bei Leistungen von 5mW und Pulsbreiten von einigen Nanosekunden aus.

Besonders positive Effekte werden durch das erfindungsgemäße Trocknungsverfahren erzielt, wenn dieses für Schichten angewandt wird, die aus Lösungen bzw. Dispersionen enthaltend organische Leiter, Halbleiter oder Farbfilter aufgebracht werden, welche mindestens ein schwerflüchtiges bzw. höhersiedendes Lösemittel enthalten; höhersiedende Lösemittel haben i. d. R. eine Siedepunkt von mindestens 120°C, bevorzugt von mehr als 150°C; schwerflüchtige Lösemittel weisen Verdampfungsenthalpien von mehr als 1000 J/g, bevorzugt mehr als 1500 J/g auf.

Wie oben beschrieben, zeichnen sich die derart erzeugten Schichten vor allem durch eine sehr gute Morphologie, ohne bei diesem Phänomen an eine besondere Theorie gebunden zu sein, und weitere günstige Eigenschaften, wie eine verringerte Einsatzspannung für die Elektrolumineszenz, einen verbesserten Stromfluß und/oder eine erhöhte Effizienz in Cd/A aus (Näheres kann den Beispielen 3-8 entnommen werden!).

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Verfahren zur Trocknung von organischen Naßfilmen ableiten und diese anwenden, um daraus organische Schichten zu erhalten.

### Beispiel 1: Vergleichsbeispiel; Filmbildung und Deviceeigenschaften von polymeren Licht-emittierenden Dioden (PLEDs) erzeugt mit Lösungen aus Tetralin mit konventioneller Trocknung.

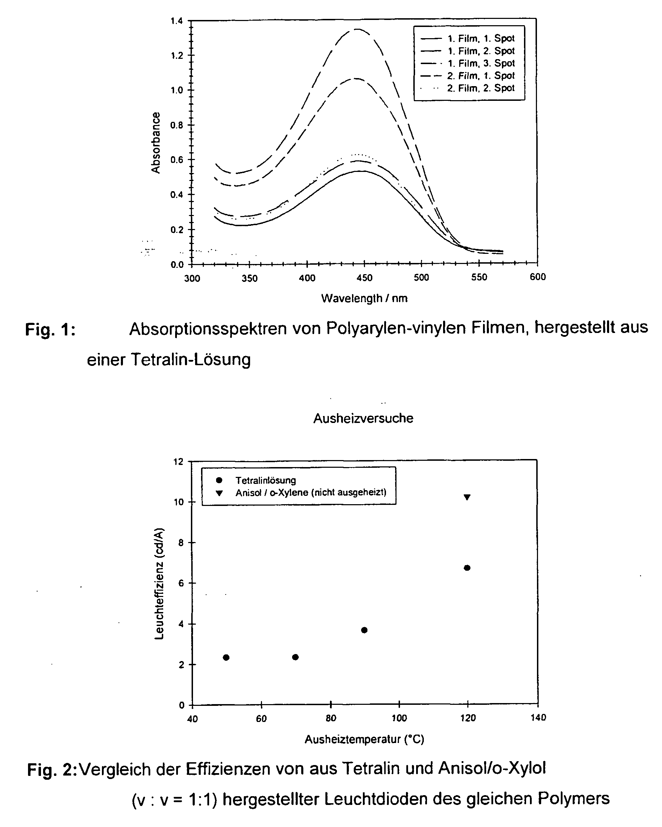

Dünne Schichten organischer Halbleiter, die mittels Spincoaten aus Tetralinlösungen aufgebracht wurden, zeigen bei Trocknung auf einer Heizplatte eine große Inhomogenität in der Schichtdicke. Absorptionsspektren erlauben über das Lambert-Beersche Gesetz (E = ε c d) die Messung von Schichtdicken. Figur 1 zeigt die Absorptionsspektren zweier Poly-arylen-vinylen-Filme, die auf identische Weise durch Spincoaten einer Tetralin-Lösung auf Glassubstrate von 3x3 cm² hergestellt wurden. Die Schichtdicken variieren selbst auf einem Substrat um einen Faktor 2. Um homogene Filme zu erhalten, mußten die Filme 12 min auf dem Spincoater belassen und dann 10 min bei 120°C ausgeheizt werden. Diese langsame Trocknung führt in der Anwendung in Druckverfahren zu den schon angesprochenen Schwierigkeiten. Trotz der langen Trocknungszeit blieb der Restgehalt an Lösemittel so groß, daß die Effizienzen aus Tetralin hergestellter polymerer Leuchtdioden diejenigen aus Anisol/o-Xylol (v : v = 1:1) nicht erreichten (s. Figur 2). Sowohl von der erhaltenen Filmqualität als auch aufgrund der langen Trocknungszeit ist die Verwendung einer Heizplatte zum Trocknen von Filmen organischer Halbleiter, organischer Leiter oder organischer Farbfilter daher nicht bevorzugt.

### Beispiel 2: Vergleichsbeispiel. Infrarot Bestrahlung eines photolumineszierenden Polymers mit und ohne zusätzlichen UV-Filter.

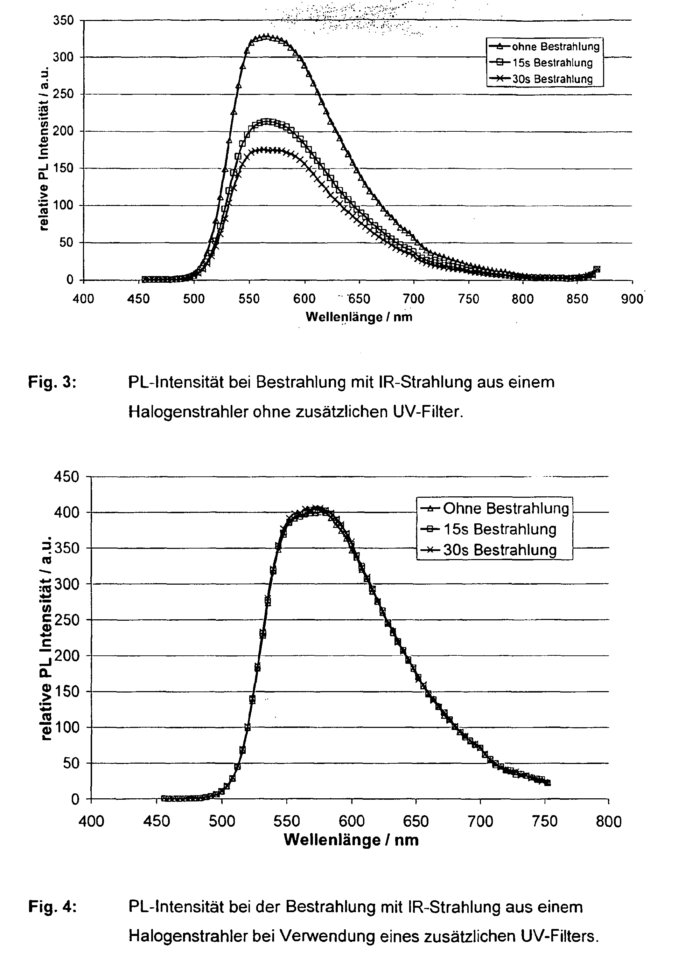

Die Bestrahlung von organischen photolumineszierenden Materialien mit UV Licht führt in der Regel zur Photodegradation des Materials. Diese Photodegradation macht sich in einer deutlichen Verringerung der PL Intensität des organischen Materials bemerkbar. In Fig. 3 sind die PL Spektren von Polymer-Material dargestellt, welches ohne einen zusätzlichen UV Filter mit Strahlung aus einer Halogenlampe bestrahlt wurde. Das Material zeigt bereits nach einer Bestrahlungszeit von 15s einen deutlichen Verlust an PL-Intensität. Dieser Verlust verstärkt sich bei Verlängerung der Bestrahlungszeit auf 30s weiter.

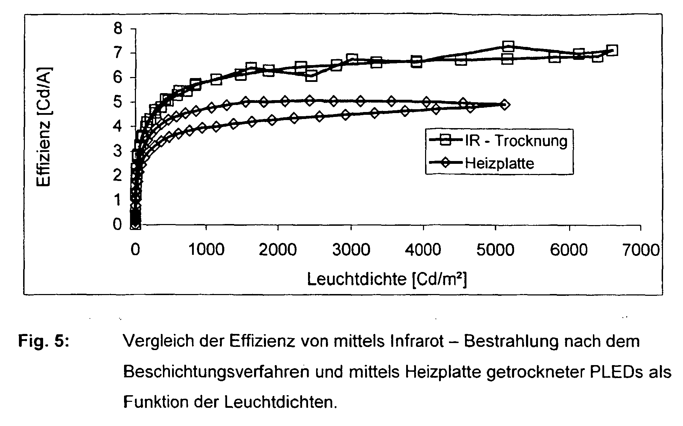

Wird nun zusätzlich ein UV Filter verwendet, so ist bei Bestrahlungszeiten von 30s und 15s keine Degradation der PL Intensität festzustellen, wie in Fig. 4 dargestellt ist.

### Beispiel 3: Verfahren zur Herstellung von Test - Dioden

Zur Charakterisierung der PLEDs wurden Test - Dioden via Spin - Coating (Lackschleudern) und nicht durch aufwendigere Druckverfahren erzeugt. Im einzelnen wurde wie folgt vorgegangen:
Die Substrate (ITO, ca. 150 nm auf Glas) wurden durch Ultrabeschallung in Wasser mit einem Spülmittel gereinigt und anschließend durch Einwirken von UV-Strahlung in einem Ozon-Plasma weiter vorbereitet.
Auf die so präparierten Substrate wurde zunächst eine dünne Schicht (ca. 20-30 nm) eines organischen Leiters (PEDOT, kommerziell als BAYTRON P^{™} von BAYER erhältlich, oder Pani, kommerziell von Ormecon erhältlich) per Spin - Coating (Lackschleudern) aufgebracht. Die Trocknung dieser Schicht (Trocknungsschritt I) erfolgte entweder mittels einer Heizplatte oder durch Infrarot - Bestrahlung. Anschließend wurden diese Substrate in eine Glove-Box transferiert (Ausschluß von Luft!). Hier wurden dann die Schichten lichtemittierender Polymere ebenfalls durch Spin - Coating (Lackschleudern) der Lösungen der entsprechenden Polymere aufgebracht (Schichtdicke ca. 60-90 nm). Die Trocknung dieser Schichten (Trocknungsschritt II) erfolgte mittels einer Heizplatte oder durch Infrarot - Bestrahlung.
Darauf wurde dann die Kathode durch thermische Verdampfung im Hochvakuum (< 10⁻⁶ mbar) aufgebracht. Für die hier beschriebenen Ergebnisse wurde eine Doppelkathode bestehend aus Barium (ca. 9 nm) und Silber (ca. 100 nm) verwendet.
Die so erzeugten Test - Dioden (PLEDs) wurden standardmäßig kontaktiert und auf ihr elektro - optischen Charakteristika untersucht.

### Beispiel 4: Trocknung von Lösungen organischer Halbleiter in Tetralin. I. Trocknung nach dem Beschichten.

Die Test - Dioden (PLEDs) wurden entsprechend Beispiel 3 hergestellt. Trocknungsschritt 1 für den organischen Leiter wurde mittels einer Heizplatte durchgeführt. Es wurden Lösungen polymerer organischer Halbleiter in Tetralin zur Beschichtung mit dem lichtemittierenden Polymer für 12 Minuten auf dem Spincoater aufgeschleudert und im Anschluß daran für 20 Sekunden der Infrarot - Strahlung ausgesetzt (Trocknungsschritt II). Die erhaltenen Effizienzen sind in Fig. 5 mit den Effizienzen von Standarddevices verglichen, bei denen der Trocknungschritt II der Polymer - Filme auf einer Heizplatte für 10 Minuten bei 120°C erfolgte. Die erhaltenen Effizienzen der per Infrarot - Bestrahlung getrockneten PLED liegen um 30% über denen der mittels einer Heizplatte getrockneten PLED.

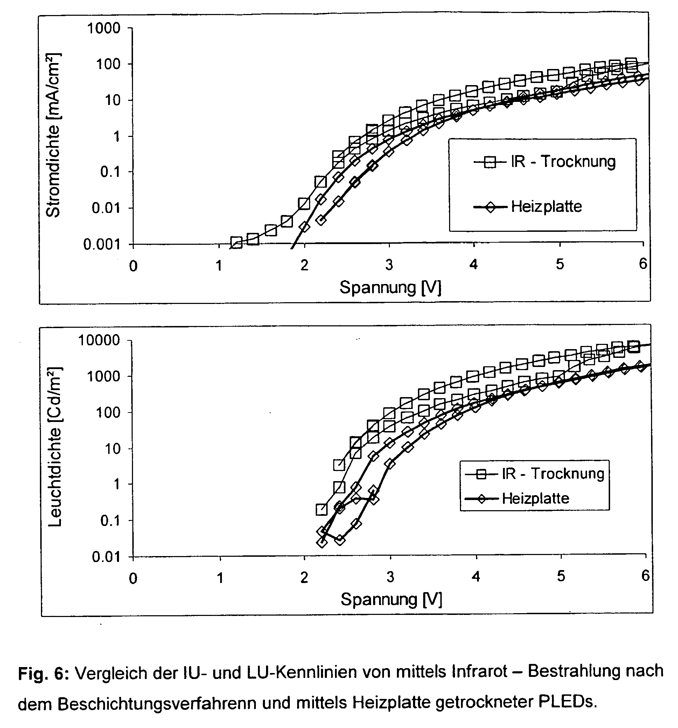

Überraschenderweise erhält man nicht nur eine Verbesserung der Effizienzen. Bei gleicher Betriebsspannung sind Stromdichte und Leuchtdichte der PLEDs, bei denen Trocknungsschritt 11 mittels Infrarot - Strahlung durchgeführt wurde, um einen Faktor 3 bzw. 6 gegenüber den PLEDs erhöht, bei denen Trocknungsschritt II mittels einer Heizplatte erfolgte, wie in Fig. 6 dargestellt ist.

### Beispiel 5: Trocknung von Lösungen organischer Halbleiter in Tetralin. II. Trocknung während des Beschichtens.

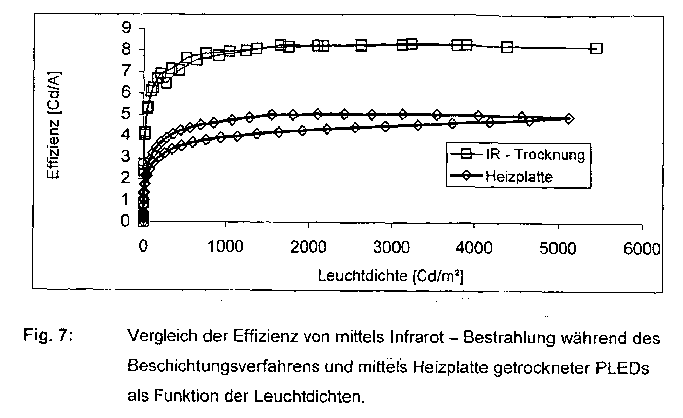

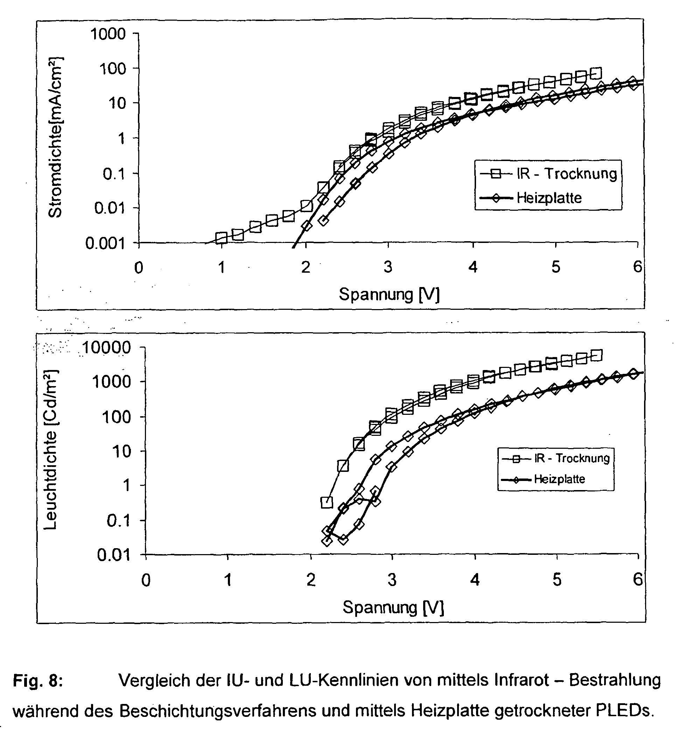

Wie in Beispiel 4 dargestellt, muß zur Gewährleistung einer homogenen Schichtqualität die Test - Diode beim konventionellen Prozeß vor dem Trocknungsschritt 11 für 12 Minuten auf dem Spin - Coater verbleiben. Bei geringeren Spin - Coating Zeiten von unter 12 Minuten erhält man bei Verwendung von Tetralin als Lösungsmittel und bei Trocknung mittels Heizplatte oder Infrarot - Strahlung Filme, die eine große Inhomogenität der Schichtdicke aufweisen. Eine Verbesserung der Prozeßzeiten bei verbesserten Schichthomogenitäten und Device-Effizienzen kann durch das im folgenden dargestellte Verfahren erreicht werden. Überraschenderweise kann der Beschichtungsprozeß in Verbindung mit der Infrarot - Bestrahlung enorm verkürzt werden, indem man nach dem Applizieren der Polymerlösung das Substrat für einige Sekunden auf dem Spin - coater dreht und dann noch während dieses Beschichtungsprozesses mit der Trocknung mittels Infrarot - Strahlung beginnt (Trocknungsschritt II in Beispiel 3 beginnt dann bereits während der Beschichtung). Man erhält so Filme mit verbesserter Morphologie, ohne bei diesem Phänomen an eine besondere Theorie gebunden zu sein. Die erhaltenen Effizienzen im Vergleich zu einem Testdevice, bei dem der Trocknungsschritt II nach 12 Minuten Spin - coaten durch 10 Minuten auf der Heizplatte bei 120°C erreicht durchgeführt wurde, sind in Fig. 7 dargestellt. Wie zu erkennen ist, erhält man mit der Infrarot - Bestrahlung die bereits während des Beschichtens stattfindet deutlich verbesserte Werte.
Überraschenderweise erhält man darüber hinaus durch die Infrarot - Bestrahlung auch eine deutliche Verbesserung der Kennlinien wie in Fig. 8 dargestellt. Bei gleicher Spannung sind die erhaltenen Strom- und Leuchtdichten der Infrarot - Bestrahlten PLED um einen Faktor 3 bzw. 6 über denen der mittels einer Heizplatte getrockneten PLED.

### Beispiel 6: Trocknung von wasserbasierten Dispersionen/Lösungen: I. PEDOT

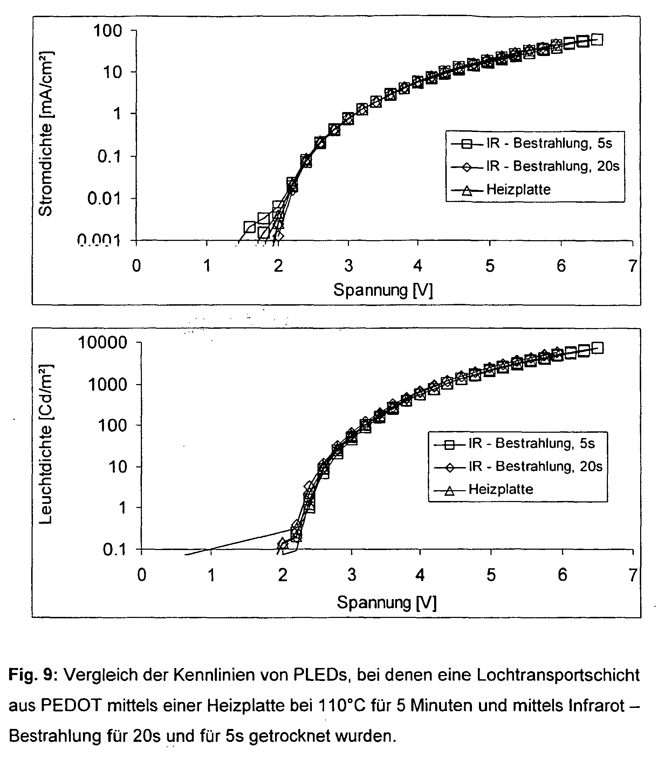

Es wurden PEDOT(kommerziell als BAYTRON P^{™} von BAYER erhältlich) - Filme nach dem Spin - coating zur Durchführung des Trocknungsschrittes I (entsprechend Beispiel 3) mit Infrarot Strahlung bestrahlt. Die Effizienzen der daraus entsprechend Beispiel 3 erhaltenen PLEDs sind identisch mit denen von PLEDs, bei denen der Trocknungsschritt I der PEDOT - Schicht mittels einer Heizplatte erfolgte. Die Prozesszeiten bei Verwendung von Infrarot Strahlung sind jedoch wesentlich verkürzt. Gute Ergebnisse wurden mit Bestrahlungszeiten von 20s, bevorzugt von 5s erhalten. Bei den Vergleichsbauteilen wurde die PEDOT - Schicht auf einer Heizplatte bei 110°C für 5 Minuten getrocknet. Die Kennlinien der PLEDs sind in Fig. 9 dargestellt.

### Beispiel 7: Trocknung von wasserbasierten Dispersionen/Lösungen: II. Pani

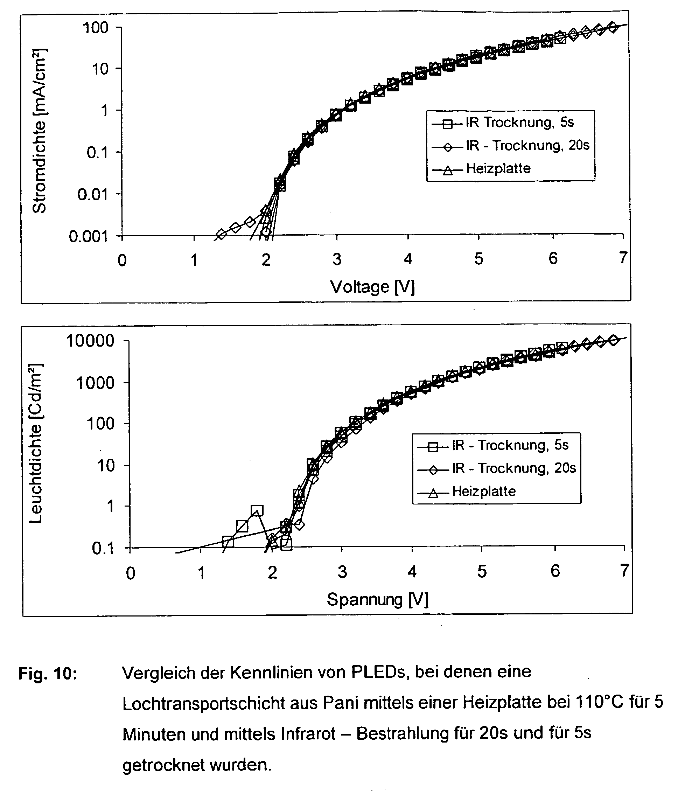

Es wurden Pani - Filme nach dem Spin - coating zur Durchführung des Trocknungsschrittes I (entsprechend Beispiel 3) mit Infrarot Strahlung bestrahlt. Die Effizienzen der daraus entsprechend Beispiel 3 erhaltenen PLEDs sind identisch mit denen von PLEDs, bei denen der Trocknungsschritt I der Pani - Schicht mittels einer Heizplatte erfolgte. Die Prozesszeiten bei Verwendung von Infrarot - Strahlung sind jedoch wesentlich verkürzt. Gute Ergebnisse wurden mit Bestrahlungszeiten von 20s, bevorzugt von 5s erhalten. Bei den Vergleichsbauteilen wurde die Pani - Schicht auf einer Heizplatte bei 110°C für 5 Minuten getrocknet. Die Kennlinien der PLEDs sind in Fig. 10 dargestellt.

### Beispiel 8: Vergleich von PLEDs, bei denen die organischen Schichten nach der Trocknung mit Infrarot - Bestrahlung behandelt wurden.

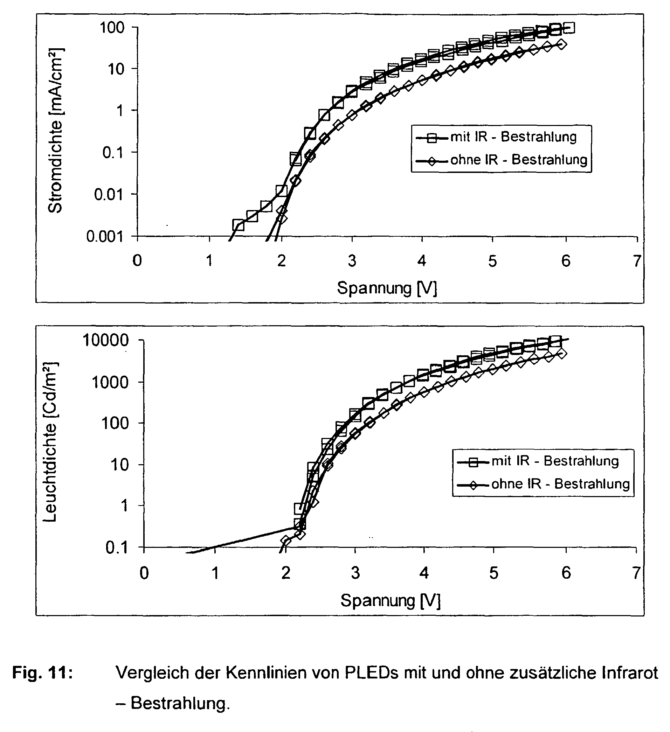

Überraschender weise wurde festgestellt, daß die Bestrahlung von PLEDs nach dem Trocknungsschritt II, also nach der Trocknung der leitenden organischen Schicht und der Schicht der lichtemittierenden Polymere der PLEDs, eine erhebliche Verbesserung der Kennlinien zur Folge hat. Es wurden dabei bereits beschichtete Polymer - Filme, bei denen Trocknungsschritt I und II durch eine Heizplatte durchgeführt wurde nach erfolgtem Trocknungsschritt II zusätzlich einer IR-Bestrahlung ausgesetzt. Die aus diesen Polymer - Filmen erhaltenen Testdevices sind in Fig. 11 mit Testdevices verglichen, die nach der Trocknung (Trocknungsschritt I & II ebenfalls mittels Heizplatte) keiner zusätzlichen IR-Bestrahlung ausgesetzt waren. Man findet eine Erhöhung der Stromdichten und Leuchtdichten bei gleicher Spannung um einen Faktor 3 bzw. um einen Faktor 2.5.

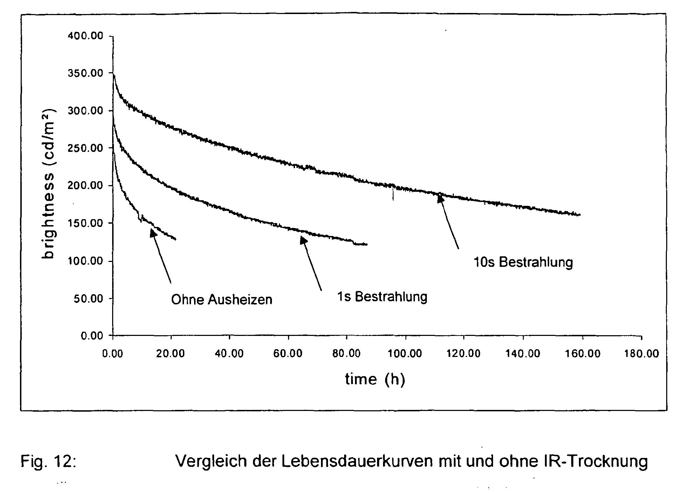

**Beispiel 9:** Vergleich von PLEDs, bei denen die elektrolumineszierende organische Schicht nach der Applikation des Films mit Infrarot-Bestrahlung behandelt wurde Überraschenderweise wurde festgestellt, daß die Bestrahlung von PLEDs auch auf ihre Lebensdauer einen sehr positiven Einfluß hat. Figur 12 zeigt einen Vergleich der Lebensdauerkurven eines lichtemittierenden Polymers ohne und mit 1s bzw. 10s IR-Trocknen. Die Lebensdauer ist durch den Trocknungsschritt deutlich erhöht.

## Patentansprüche

1. Verfahren zur Erzeugung dünner Schichten von organischen Halbleitern, organischen Leitern oder organischen Farbfiltern umfassend die Schritte:
(a) Aufbringen von Lösungen oder Dispersionen enthaltend mindestens einen organischen Halbleiter oder organischen Leiter oder organischen Farbfilter auf ein Substrat,
(b) Trocknung des gemäß Schritt (a) erzeugten Naßfilms und gegebenenfalls
(c) Nachbehandlung der gemäß Schritt (b) getrockneten Schichten organischer Halbleiter, organischer Leiter oder organischer Farbfilter,
**dadurch gekennzeichnet,**
**daß** die Trocknung gemäß Schritt (b) und/oder die Nachbehandlung gemäß Schritt (c) mittels IR- und/oder NIR-Strahlung durchgeführt wird, bei der mindestens 80% der Strahlungsenergie im Bereich von 700 bis 2000 nm liegt.

2. Verfahren gemäß Anspruch 1, **dadurch gekennzeichnet, daß** die Strahlungsintensität der eingesetzten Strahlung größer 75 kW/m² ist.

3. Verfahren gemäß Anspruch 1 oder 2, **dadurch gekennzeichnet, daß** die getrocknete Festfilmschicht weniger als 1% (bezogen auf die Masse) Lösemittel enthält.

4. Verfahren gemäß Anspruch 1 oder 2, **dadurch gekennzeichnet, daß** die getrocknete Festfilmschicht vor der Nachbehandlung einen Gehalt von mehr als 1 % (bezogen auf die Masse) Lösemittel enthält.

5. Verfahren gemäß einem oder mehrerer der Ansprüche 1 bis 4, **dadurch gekennzeichnet, daß** die Trocknung (Schritt b) unmittelbar nach der Beschichtung (Schritt a) erfolgt.

6. Verfahren gemäß einem oder mehrerer der Ansprüche 1 bis 4, **dadurch gekennzeichnet, daß** die Trocknung (Schritt b) schon während des Beschichtens (Schritt a) begonnen wird.

7. Verfahren gemäß einem oder mehrerer der Ansprüche 1 bis 6, **dadurch gekennzeichnet, daß** die Lösungen bzw. Dispersionen enthaltend organische Leiter, Halbleiter oder Farbfilter mindestens ein höhersiedendes Lösemittel enthält, dessen Siedepunkt von mindestens 120°C beträgt.

8. Verfahren gemäß einem oder mehrerer der Ansprüche 1 bis 6, **dadurch gekennzeichnet, daß** die Lösungen bzw. Dispersionen enthaltend organische Leiter, Halbleiter oder Farbfilter mindestens ein schwerflüchtiges Lösemittel enthält, dessen Verdampfungsenthalpie mehr als 1000 J/g beträgt.

9. Verfahren gemäß einem oder mehrerer der Ansprüche 1 bis 8, **dadurch gekennzeichnet, daß** die nachbehandelte Festfilmschicht weniger als 1 % (bezogen auf die Masse) Lösemittel enthält.

10. Verwendung von mindestens einem der Verfahren gemäß einem oder mehrerer der Ansprüche 1 bis 9 in der Herstellung von organischen Leuchtdioden (PLEDs), organischen integrierten Schaltungen (O-ICs), organischen Feld-Effekt-Transistoren (OFETs), organischen Dünnfilmtransistoren (OTFTs), organischen Solarzellen (O-SCs) organischen Laserdioden (O-Laser), organischen Farbfilter für Liquid-Crystal-Displays oder organischen Photorezeptoren.

## Claims

1. Process for the production of thin layers of organic semiconductors, organic conductors or organic colour filters, comprising the steps:
(a) application of solutions or dispersions comprising at least one organic semiconductor or organic conductor or organic colour filter to a substrate,
(b) drying of the wet film produced in accordance with step (a) and optionally
(c) post-treatment of the organic semiconductor, organic conductor or organic colour filter layers dried in accordance with step (b),
**characterised in that**
the drying in accordance with step (b) and/or the post-treatment in accordance with step (c) is carried out by means of IR and/or NIR radiation in which at least 80% of the radiation energy is in the range from 700 to 2000 nm.

2. Process according to Claim 1, **characterised in that** the radiation intensity of the radiation employed is greater than 75 kW/m².

3. Process according to Claim 1 or 2, **characterised in that** the dried solid-film layer comprises less than 1% (based on the weight) of solvent.

4. Process according to Claim 1 or 2, **characterised in that** the dried solid-film layer has, before the post-treatment, a content of more than 1% (based on the weight) of solvent.

5. Process according to one or more of Claims 1 or 4, **characterised in that** the drying (step b) is carried out immediately after the coating (step a).

6. Process according to one or more of Claims 1 to 4, **characterised in that** the drying (step b) is begun even during the coating (step a).

7. Process according to one or more of Claims 1 to 6, **characterised in that** the solutions or dispersions comprising organic conductors, semiconductors or colour filters comprise at least one relatively high-boiling solvent whose boiling point is at least 120°C.

8. Process according to one or more of Claims 1 to 6, **characterised in that** the solutions or dispersions comprising organic conductors, semiconductors or colour filters comprise at least one low-volatility solvent whose enthalpy of evaporation is greater than 1000 J/g.

9. Process according to one or more of Claims 1 to 8, **characterised in that** the post-treated solid-film layer comprises less than 1 % (based on the weight) of solvent.

10. Use of at least one of the processes according to one or more of Claims 1 to 9 in the production of organic light-emitting diodes (PLEDs), organic integrated circuits (O-ICs), organic field-effect transistors (OFETs), organic thin-film transistors (OTFTs), organic solar cells (O-SCs), organic laser diodes (O-lasers), organic colour filters for liquid-crystal displays or organic photoreceptors.

## Revendications

1. Procédé pour la production de couches minces de semiconducteurs organiques, de conducteurs organiques ou de filtres couleur organiques, comprenant les étapes de :
(a) application de solutions ou de dispersions comprenant au moins un semiconducteur organique ou un conducteur organique ou un filtre couleur organique sur un substrat,
(b) séchage du film humide produit conformément à l'étape (a) et en option
(c) post-traitement des couches de semiconducteurs organiques, de conducteurs organiques ou de filtres couleur organiques séchées conformément à l'étape (b),
**caractérisé en ce que**
le séchage conformément à l'étape (b) et/ou le post-traitement conformément à l'étape (c) sont mis en oeuvre au moyen d'un rayonnement infrarouge (IR) et/ou des infrarouges proches (NIR) selon lequel au moins 80% de l'énergie de rayonnement est dans la plage de 700 à 2000 nm.

2. Procédé selon la revendication 1, **caractérisé en ce que** l'intensité de rayonnement du rayonnement utilisé est supérieure à 75 kW/m².

3. Procédé selon la revendication 1 ou 2, **caractérisé en ce que** la couche en film solide séchée comprend moins de 1 % (sur la base du poids) de solvant.

4. Procédé selon la revendication 1 ou 2, **caractérisé en ce que** la couche en film solide séchée présente, avant le post-traitement, une teneur supérieure à 1% (sur la base du poids) de solvant.

5. Procédé selon une ou plusieurs des revendications 1 ou 4, **caractérisé en ce que** le séchage (étape b) est mis en oeuvre immédiatement après le dépôt (étape a).

6. Procédé selon une ou plusieurs des revendications 1 à 4, **caractérisé en ce que** le séchage (étape b) est démarré même pendant le dépôt (étape a).

7. Procédé selon une ou plusieurs des revendications 1 à 6, **caractérisé en ce que** les solutions ou dispersions comprenant des conducteurs organiques, des semiconducteurs organiques ou des filtres couleur organiques comprennent au moins un solvant d'ébullition relativement élevée dont le point d'ébullition est à au moins 120°C.

8. Procédé selon une ou plusieurs des revendications 1 à 6, **caractérisé en ce que** les solutions ou dispersions comprenant des conducteurs organiques, des semiconducteurs organiques ou des filtres couleur organiques comprennent au moins un solvant de volatilité faible dont l'enthalpie d'évaporation est supérieure à 1000 J/g.

9. Procédé selon une ou plusieurs des revendications 1 à 8, **caractérisé en ce que** la couche en film solide post-traitée comprend moins de 1 % (sur la base du poids) de solvant.

10. Utilisation d'au moins l'un des procédés selon une ou plusieurs des revendications 1 à 9 au niveau de la production de diodes émettrices de lumière organiques (PLED), de circuits intégrés organiques (O-IC), de transistors à effet de champ organiques (OFET), de transistors à film mince organiques (OTFT), de cellules solaires organiques (O-SC), de diodes laser organiques (O-lasers), de filtres couleur organiques pour des affichages à cristaux liquides ou pour des photorécepteurs organiques.
